(19) Europäisches Patentamt / European Patent Office / Office européen des brevets

(11) **EP 4 632 400 A1**

(12) **EUROPEAN PATENT APPLICATION**
published in accordance with Art. 153(4) EPC

(43) Date of publication:
**15.10.2025 Bulletin 2025/42**

(21) Application number: **23907596.3**

(22) Date of filing: **14.12.2023**

(51) International Patent Classification (IPC):
*G01R 31/367* (2019.01)   *G01R 31/385* (2019.01)
*G01R 31/392* (2019.01)   *H01M 10/42* (2006.01)
*H01M 10/48* (2006.01)    *G01N 33/00* (2006.01)

(52) Cooperative Patent Classification (CPC):
**G01N 33/00; G01R 31/367; G01R 31/385;
G01R 31/392; H01M 10/42; H01M 10/48**

(86) International application number:
**PCT/KR2023/020680**

(87) International publication number:
**WO 2024/136310 (27.06.2024 Gazette 2024/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.12.2022 KR 20220182369
07.11.2023 KR 20230153022**

(71) Applicant: **LG Energy Solution, Ltd.
Seoul 07335 (KR)**

(72) Inventors:
• **LEE, Cho Long**
  **Daejeon 34122 (KR)**
• **KOH, Dong Wook**
  **Daejeon 34122 (KR)**
• **LEE, Ho Jin**
  **Daejeon 34122 (KR)**

(74) Representative: **Plasseraud IP
104 Rue de Richelieu
CS92104
75080 Paris Cedex 02 (FR)**

(54) **DEVICE FOR PREDICTING AMOUNT OF GAS GENERATED IN BATTERY AND OPERATION METHOD THEREOF**

(57)    A gas generation amount prediction apparatus according to an embodiment disclosed herein includes an obtaining unit configured to obtain measurement data regarding a voltage, a current, and a temperature of a battery, a calculating unit configured to calculate a cathode side reaction (CSR) and an anode side reaction (ASR), based on the measurement data, and a predicting unit configured to predict a gas generation amount of the battery, based on the CSR and the ASR.

FIG.1

Processed by Luminess, 75001 PARIS (FR)

Description

[Technical Field]

CROSS-REFERENCE TO RELATED APPLICATION

This application claims priority to and the benefit of Korean Patent Application No. 10-2022-0182369 filed in the Korean Intellectual Property Office on December 22, 2022, and Korean Patent Application No. 10-2023-0153022 filed in the Korean Intellectual Property Office on November 7, 2023, the entire contents of which are incorporated herein by reference.

TECHNICAL FIELD

Embodiments disclosed herein relate to a battery gas generation amount prediction apparatus and an operating method thereof.

[Background Art]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.
A battery management system (BMS) is one of services related to secondary batteries. The BMS may collect data regarding the voltage, current, and temperature of the battery. The BMS may diagnose internal shortcircuit, over-voltage, temperature sensor failure, venting, and other failures of the battery, based on collected measurement data. Herein, venting refers to a phenomenon in which internal temperature and pressure of the battery increase due to generation of a gas in the battery.
An increase of the internal pressure of the battery continuously due to venting may result in fire and explosion due to discharge of a large amount of gas from the battery.

[Disclosure]

[Technical Problem]

Venting may occur due to the gas generated inside the battery. Thus, it is necessary to accurately measure a gas generation amount of the gas generated in the battery.
To measure the gas generation amount of the battery, the gas generated in the battery needs to be directly measured using the sensor.
However, when the gas generation amount of the battery is directly measured, venting may not be diagnosed early.
Technical problems of the embodiments disclosed herein are not limited to the above-described technical problems, and other unmentioned technical problems would be clearly understood by one of ordinary skill in the art from the following description.

[Technical Solution]

A gas generation amount prediction apparatus according to an embodiment disclosed herein includes an obtaining unit configured to obtain measurement data regarding a voltage, a current, and a temperature of a battery, a calculating unit configured to calculate a cathode side reaction (CSR) and an anode side reaction (ASR), based on the measurement data, and a predicting unit configured to predict a gas generation amount of the battery, based on the CSR and the ASR.
In an embodiment, the predicting unit may be further configured to identify a gas generation speed of the battery based on a density of an oxidation reactant and a change rate of the CSR and predict the gas generation amount based on the gas generation speed.
In an embodiment, the predicting unit may be further configured to identify a change rate of the density of the oxidation reactant based on a density of a reduction by-product and a change rate of the ASR.

In an embodiment, the predicting unit may be further configured to identify the density of the reduction by-product based on the temperature.

In an embodiment, the gas generation amount prediction apparatus may further include a model managing unit configured to generate a gas generation amount prediction model based on a model governing equation and change one or more parameters included in the model governing equation, in which the predicting unit is further configured to predict the gas generation amount of the battery by using the gas generation amount prediction model.

In an embodiment, the gas generation amount prediction apparatus may further include a comparing unit configured to compare a gas generation amount predicted by the gas generation amount prediction model with an actual gas generation amount, in which the model managing unit is further configured to change the one or more parameters included in the model governing equation based on the comparison result.

In an embodiment, the model governing equation may include an equation based on the gas generation amount and an interactive relationship for CSR-ASR.

An operating method of a gas generation amount prediction apparatus according to an embodiment disclosed herein includes obtaining measurement data regarding a voltage, a current, and a temperature of a battery, calculating a cathode side reaction (CSR) and an anode side reaction (ASR), based on the measurement data, and predicting a gas generation amount of the battery, based on the CSR and the ASR.

In an embodiment, the predicting may include identifying a gas generation speed of the battery based on a density of an oxidation reactant and a change rate of the CSR, and in which the gas generation amount is predicted based on the gas generation speed.

In an embodiment, the predicting may further include identifying a change rate of the density of the oxidation reactant based on a density of a reduction by-product and a change rate of the ASR.

In an embodiment, the predicting may further include identifying the density of the reduction by-product based on the temperature.

In an embodiment, the operating method may further include generating a gas generation amount prediction model based on a model governing equation, in which the predicting includes predicting the gas generation amount of the battery by using the gas generation amount prediction model.

In an embodiment, the operating method may further include comparing a gas generation amount predicted by the gas generation amount prediction model with an actual gas generation amount and changing one or more parameters included in the gas generation amount prediction model, based on the comparison result.

In an embodiment, the model governing equation may include an equation based on the gas generation amount and an interactive relationship for CSR-ASR.

**[Advantageous Effects]**

A battery gas generation amount prediction apparatus and an operating method thereof according to various embodiments disclosed herein may predict a gas generation amount of the battery merely with measurement data regarding voltage, current, and temperature of the battery by using a gas generation amount prediction model.

The battery gas generation amount prediction apparatus and the operating method thereof according to various embodiments disclosed herein may change a parameter of a gas generation amount prediction model based on a result of comparing an actual gas generation amount and a predicted gas generation amount.

Thus, the battery gas generation amount prediction apparatus and the operating method thereof may prevent an accident from occurring due to explosion of the battery by previously performing diagnosis with respect to a risk of venting based on the gas generation amount predicted by the gas generation amount prediction model.

The effects of the battery gas generation amount prediction apparatus and the operating method thereof according to the disclosure of the present document are not limited to the effects mentioned above, and other effects not mentioned will be clearly understood by those of ordinary skill in the art according to the disclosure of the present document.

**[Description of Drawings]**

FIG. 1 is a block diagram of a battery gas generation amount prediction apparatus according to an embodiment of the present disclosure.

FIG. 2 shows a coordinate system showing a predicted gas generation amount and an actual gas generation amount according to an embodiment of the present disclosure.

FIG. 3 is a flowchart showing a method of generating and changing a gas generation amount prediction model according to an embodiment of the present disclosure.

FIG. 4 is a flowchart showing an operating method of a battery gas generation amount prediction apparatus according to an embodiment of the present disclosure.

With regard to the description of the drawings, similar reference numerals may be used to refer to similar or related components.

**[Mode for Invention]**

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

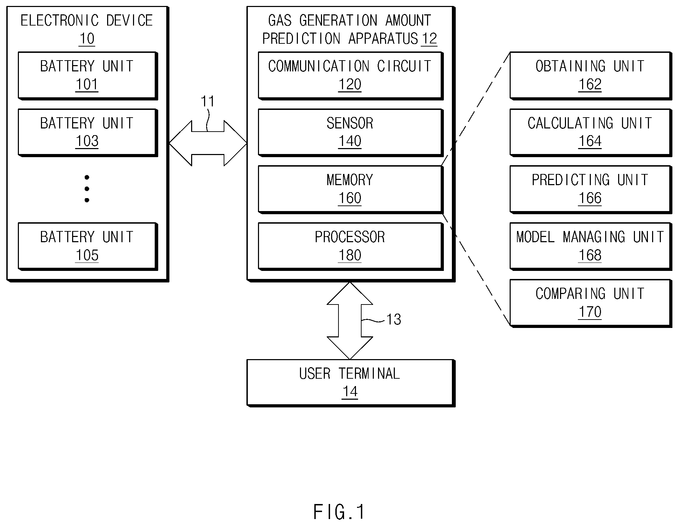

FIG. 1 is a block diagram of a battery gas generation amount prediction apparatus 12 according to an embodiment of the present disclosure.

Referring to FIG. 1, the battery gas generation amount prediction apparatus 12 may be wiredly and/or wirelessly connected to an electronic device 10 and a user terminal 14.

In an embodiment, connection 11 between the battery gas generation amount prediction apparatus 12 and the electronic device 10 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

In another embodiment, the connection 11 between the battery gas generation amount prediction apparatus 12 and the electronic device 10 may be connection using a device-to-device communication scheme (e.g., a bus, a general-purpose input and output (GPIO), a serial peripheral interface (SPI), or a mobile industry processor interface (MIPI)).

In an embodiment, connection 13 between the battery gas generation amount prediction apparatus 12 and the user terminal 14 may be communication connection through a wired and/or wireless network.

In an embodiment, the electronic device 10 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), a battery swapping system (BSS), or a battery management system (BMS).

In an embodiment, the electronic device 10 may include one or more battery units 101, 103, and 105. Each of the one or more battery units 101, 103, and 105 may be a battery cell, a battery module, a battery pack, or a battery rack.

In an embodiment, the user terminal 14 may be a mobile device (e.g., a mobile phone, a laptop computer, a smart phone, a smart pad), or a personal computer (PC).

In an embodiment, the battery gas generation amount prediction apparatus 12 may include a communication circuit 120, a sensor 140, a memory 160, and a processor 180. According to an embodiment, the battery gas generation amount prediction apparatus 12 shown in FIG. 1 may further include at least one component (e.g., a display, an input device, or an output device) in addition to components shown in FIG. 1.

In an embodiment, the communication circuit 120 may establish a wired communication channel and/or a wireless communication channel between the battery gas generation amount prediction apparatus 12 and the electronic device 10 and/or the user terminal 14, and transmit and receive data to and from the electronic device 10 and/or the user terminal 14 through the established communication channel.

In an embodiment, the sensor 140 may obtain values related to states of the battery units 101, 103, and 105 of the electronic device 10. In an embodiment, the values related to the states may indicate one or more values of voltages, currents, resistances, SOC, states of health (SOH), or temperatures of the battery units 101, 103, and 105 or combinations thereof. Hereinbelow, the value related to the state may be referred to as a 'state value'.

In an embodiment, the memory 160 may include a volatile and/or a nonvolatile memory.

In an embodiment, the memory 160 may store data used by at least one component (e.g., the processor 180) of the battery gas generation amount prediction apparatus 12. For example, the data may include software (or an instruction related thereto), input data, or output data. In an embodiment, an instruction, when executed by the processor 180, may cause the battery gas generation amount prediction apparatus 12 to perform operations defined by the instruction.

In an embodiment, the memory 160 may include one or more software (e.g., an obtaining unit 162, a calculating unit 164, a predicting unit 166, a model managing unit 168, and a comparing unit 170).

In an embodiment, the processor 180 may include a central processing unit, an application processor, a graphic processing unit, a neural processing unit (NPU), an image signal processor, a sensor hub processor, or a communication processor.

In an embodiment, the processor 180 may execute software (e.g., the obtaining unit 162, the calculating unit 164, the predicting unit 166, the model managing unit 168, and the comparing unit 170) to control at least one other component (e.g., a hardware or software component) of the battery gas generation amount prediction apparatus 12 connected to the processor 180 and perform various data processing or operations.

Hereinbelow, operations performed in the obtaining unit 162, the calculating unit 164, the predicting unit 166, the model managing unit 168, and the comparing unit 170 will be described.

Gas Generation Amount Model Generation

The model managing unit 168 may generate a gas generation amount prediction model. Herein, the gas generation amount prediction model may predict a gas generation amount of the battery based on measurement data. Herein, the measurement data may include a state value related to a voltage, a current, a temperature, a state of charge (SOC), a state of health (SOH) of the battery, or a combination thereof.

The model managing unit 168 may establish a model governing equation. The model managing unit 168 may establish the model governing equation to generate the gas generation amount prediction model. The model managing unit 168 may establish the model governing equation based on test data. The model managing unit 168 may establish the model governing equation, which is a basis for the gas generation amount prediction model, based on the test data. Herein, the test data may include the measurement data including a state value regarding degraded test batteries. The test data may include cathode side reaction (CSR) and anode side reaction (ASR) calculated based on measurement data of a plurality of test batteries. The test data may include a correlation between the gas generation amount and the CSR and a correlation between the gas generation amount and the ASR. Herein, the CSR may be a side reaction amount in a positive electrode of the battery, and the ASR may be a side reaction amount in a negative electrode of the battery.

According to an embodiment, the CSR and the ASR may be calculated based on the test data. The CSR and the ASR may be calculated based on the measurement data regarding degraded test batteries included in the test data. Herein, the test data may include data derived in advance through batteries of the same type as the test batteries. For example, the test data may include information regarding an open circuit potential (OCP) of a positive electrode regarding batteries, an OCP of a negative electrode, and an open circuit voltage (OCV) of a full cell. The test data may include information about a value of an OCV (and/or OCP) with respect to an SOC. The test data may include information about a change rate of an OCV (and/or OCP) with respect to an SOC.

In an embodiment, the ASR and the CSR may be calculated based on a theoretical capacity, an OCV change amount, and an SOH change amount of the full cell. More specifically, the ASR and the CSR may be calculated based on Equation 1.

[Equation 1]

$$\begin{bmatrix} \Delta c_{ASR} \\ \Delta c_{CSR} \end{bmatrix} = \begin{bmatrix} 1 & -1 \\ \dfrac{\partial U_n}{\partial c}^{k-1} & -\dfrac{\partial U_p}{\partial c}^{k-1} \end{bmatrix}^{-1} \begin{bmatrix} -\Delta SOH_{OCV} \cdot c_{OCV,fullcell}^{k=0} \\ \Delta OCV \end{bmatrix}$$

In Equation 1, $\triangle C_{ASR}$ may indicate a change amount of a side reaction amount of the negative electrode between the first timepoint (k-1) and a second timepoint k, and $\triangle C_{CSR}$ between the first timepoint (k-1) and the second timepoint k may indicate a change amount of a side reaction amount of the positive electrode.

In Equation 1, $\dfrac{\delta U_n^{k-1}}{\delta c}$ may indicate a slope of a capacity (c)-negative electrode equilibrium potential ( $U_n^{k-1}$ ) at the timepoint (k-1), and $\dfrac{\delta U_p^{k-1}}{\delta c}$ may indicate a slope of a capacity (c)-positive electrode equilibrium potential ( $U_p^{k-1}$ ) at the timepoint (k-1).

In Equation 1, $\triangle SOH_{OCV}$ may indicate a change amount of the SOH at a designated voltage. $c_{OCV,fullcell}^{k=0}$ may mean a theoretical capacity except for overpotential in a designated voltage range at the reference timepoint (i.e., a timepoint when k is 0, or the BoL). $\Delta OCV$ may mean a change amount of the OCV. Herein, (k-1) may mean the first timepoint, and k may mean the second timepoint. The amounts of change in Equation 1 may be identified by a value at the second timepoint with respect to a value of the first timepoint.

In an embodiment, $\dfrac{\delta U_n^{k-1}}{\delta c}$ may be calculated based on Equation 2.

[Equation 2]

$$\frac{\partial U_n}{\partial c}^{k-1} = \frac{\partial U_n}{\partial x}^{x=x^{k-1}} \cdot \frac{\partial x}{\partial c} = \frac{\dfrac{\partial U_n}{\partial x}^{x=x^{k-1}}}{c_{OCV,n}^{k=0}}$$

Referring to Equation 2, $\dfrac{\delta U_n^{k-1}}{\delta c}$ may be calculated based on a product of the amount of change $\dfrac{\delta U_n^{k-1}}{\delta x}$ of a negative potential at the timepoint (k-1) with respect to the negative electrode stoichiometry and the amount of change of a capacity-negative electrode stoichiometry. Moreover, the amount of change of the capacity-negative electrode stoichiometry may be replaced with $c_{OCV,n}^{k=0}$ indicating a negative electrode capacity in a designated voltage range. Herein, the amount of change of the negative potential at the timepoint (k-1) with respect to the negative electrode stoichiometry and the amount of change of the capacity-negative electrode stoichiometry may be included in the test data.

In an embodiment, $\dfrac{\delta U_p^{k-1}}{\delta c}$ may be calculated based on Equation 3.

[Equation 3]

$$\frac{\partial U_p^{k-1}}{\partial c} = \frac{\partial U_p^{y=y^{k-1}}}{\partial y} \cdot \frac{\partial y}{\partial c} = -\frac{\dfrac{\partial U_p^{y=y^{k-1}}}{\partial y}}{c_{OCV,p}^{k=0}}$$

Referring to Equation 3, $\dfrac{\delta U_p^{k-1}}{\delta c}$ may be calculated based on a product of the amount of change $\dfrac{\delta U_p^{k-1}}{\delta y}$ of a positive potential at the timepoint (k-1) with respect to the positive electrode stoichiometry and the amount of change of a capacity-positive electrode stoichiometry. Moreover, the amount of change of the capacity-positive electrode stoichiometry may be replaced with $-c_{OCV,p}^{k=0}$ indicating a positive electrode capacity in a designated voltage range. Herein, the amount of change of the positive potential at the timepoint (k-1) with respect to the positive electrode stoichiometry and the amount of change of the capacity-positive electrode stoichiometry may be included in the test data.

In an embodiment, the calculating unit 115 may calculate the ASR and the CSR based on the capacity-positive electrode equilibrium potential slope $\dfrac{\delta U_p^{k-1}}{\delta c}$ and the capacity-negative electrode equilibrium potential slope $\dfrac{\delta U_n^{k-1}}{\delta c}$ of the battery unit 105 at the first timepoint (i.e., k-1), as shown in Equation 1.

In an embodiment, the ASR and the CSR may be determined based on a product of a theoretical capacity $c_{OCV,fullcell}^{k=0}$ of the full cell and a SOH change amount $\triangle SOH_{OCV}$, and an OCV change amount $\triangle OCV$, as shown in Equation 1. The model governing equation may indicate a correlation between the gas generation amount and the CSR and/or the ASR. The model governing equation may be an equation based on a correlation between the gas generation amount and the CSR and/or the ASR. The model governing equation may be an equation based on the gas generation amount and an interactive relationship between the CSR-ASR (e.g., a product of the CSR and the ASR). The model governing equation may be a table based on a correlation between the gas generation amount and the CSR and/or the ASR. The model governing equation may be a table based on the gas generation amount and the interactive relationship between the CSR-ASR (e.g., a product of the CSR and the ASR). Herein, the table may be a set of predetermined results with respect to a given operation. For example, the table may be a table of gas generation amounts determined according to the CSR or the ASR. Hereinbelow, a description will be described assuming the model governing equation as an equation.

The model governing equation may include one or more equations. Herein, the one or more equations may be expressed as Equation 4 and Equation 5.

[Equation 4]

$$\frac{dC_{gas}}{dt} = k_{OR} \cdot C_{OR} \cdot \frac{dC_{CSR}}{dt}$$

[Equation 5]

$$\frac{dC_{OR}}{dt} = \frac{k_{RP}}{2} \cdot \left[\tanh\left(k_T(T - T_R)\right) + 1\right] \cdot \frac{dC_{ASR}}{dt} - k_g \cdot \frac{dC_{gas}}{dt}$$

Herein, $C_{gas}$ indicates a gas generation amount, $C_{OR}$ indicates a density of an oxidation reactant, $C_{CSR}$ indicates a density of CSR, and $C_{ASR}$ indicates a density of ASR. $k_{OR}$, $k_{RP}$, $k_T$, and $k_g$ indicate reaction rate coefficients for an oxidation reactant, a reduction by-product, a temperature, and a gas generation amount, respectively. T indicates a variable for temperature, and $T_R$ indicates a constant for temperature.

Parameter Change Method

The model managing unit 168 may change the gas generation amount prediction model. The model managing unit 168 may change the model governing equation that is a basis for the gas generation amount prediction model. The model managing unit 168 may change one or more parameters included in the model governing equation.

The comparing unit 170 may compare the predicted gas generation amount with the actual gas generation amount to change the one or more parameters. The comparing unit 170 may compare the gas generation amount, predicted by the predicting unit 166, with the actual gas generation amount. Herein, the predicted gas generation amount may be a value predicted to be the actual gas generation amount by the gas generation amount prediction model. The actual gas generation amount may be a real value obtained by measuring the actual gas generation amount of the battery using test equipment. Herein, a comparison result of comparing the predicted gas generation amount with the actual gas generation amount may include a root mean square deviation (RMSE), a determination coefficient (r-square), or a combination thereof. The RMSE and the determination coefficient may be indices for evaluating performance of the gas generation amount prediction model.

The model managing unit 168 may change the one or more parameters included in the model governing equation, based on the comparison result of comparing the predicted gas generation amount with the actual gas generation amount. The model managing unit 168 may change the one or more parameters to reduce a difference between the predicted gas generation amount and the actual gas generation amount based on the comparison result. Herein, the one or more parameters may include $k_{OR}$, $k_{RP}$, $k_T$, $k_g$, $T_R$, or a combination thereof.

The model managing unit 168 may change the gas generation amount prediction model, based on the changed one or more parameters. The model managing unit 168 may change the gas generation amount prediction model, based on the model governing equation having the changed one or more parameters applied thereto. The model managing unit 168 may generate a new gas generation amount prediction model based on the model governing equation having the changed one or more parameters applied thereto.

Gas Generation Amount Prediction Method

The obtaining unit 162 may obtain data about the battery. The obtaining unit 162 may obtain measurement data regarding a voltage, a current, and a temperature of the battery.

The calculating unit 164 may calculate the CSR and the ASR. The calculating unit 164 may calculate the CSR and the ASR based on the measurement data.

The predicting unit 166 may predict the gas generation amount of the battery. The predicting unit 166 may predict the gas generation amount of the battery, based on a gas generation speed. The predicting unit 166 may predict the gas generation amount of the battery by integrating the gas generation speed.

The predicting unit 166 may identify the gas generation speed of the battery to predict the gas generation amount of the battery. The predicting unit 166 may identify the gas generation speed of the battery based on the density of the oxidation reactant and the change rate of the CSR. Herein, the gas generation speed may be expressed as Equation 4.

The predicting unit 166 may identify a density change rate of the oxidation reactant. The predicting unit 166 may identify the density change rate of the oxidation reactant based on the density of the reduction by-product and the change rate of the ASR. The density change rate of the oxidation reactant may be expressed as Equation 6.

[Equation 6]

$$\frac{dC_{OR}}{dt} = k_{RP} \cdot C_{RP} \cdot \frac{dC_{ASR}}{dt}$$

Herein, $C_{OR}$ may indicate a density of an oxidation reactant, $C_{RP}$ may indicate a density of a reduction by-product, and $C_{ASR}$ may indicate a density of ASR. $k_{RP}$ may indicate a reaction speed coefficient for each reduction by-product.

Referring to Equation 6, the density change rate of the oxidation reactant may be proportional to the density of the reduction by-product and an electrochemical reaction speed. However, the density change rate of the oxidation reactant may be reduced as much as the gas generation amount generated by the reduction by-product. The density change rate of the oxidation reactant except for the gas generation amount generated by the reduction by-product in Equation 6 may be expressed as Equation 7.

[Equation 7]

$$\frac{dC_{OR}}{dt} = k_{RP} \cdot C_{RP} \cdot \frac{dC_{ASR}}{dt} - k_{g} \cdot \frac{dC_{gas}}{dt}$$

Herein, $C_{OR}$ may indicate a density of an oxidation reactant, $C_{RP}$ may indicate a density of a reduction by-product, $C_{ASR}$ may indicate a density of ASR, and $C_{gas}$ may indicate a density of a gas generation amount. $k_{RP}$ and $k_{g}$ indicate reaction rate coefficients for a reduction by-product and a gas generation amount, respectively.

The predicting unit 166 may identify the density of the reduction by-product. The predicting unit 166 may identify the density of the reduction by-product, based on the temperature. The density of the reduction by-product may be expressed as Equation 8.

[Equation 8]

$$C_{RP} = \frac{\tanh\left(k_{T}(T - T_{R})\right) + 1}{2}$$

Herein, $C_{RP}$ may be the density of the reduction by-product. $k_{T}$ may indicate a reaction speed coefficient for a temperature. T indicates a variable for temperature, and $T_{R}$ indicates a constant for temperature.

The predicting unit 166 may predict the gas generation amount of the battery by using the gas generation amount prediction model. The predicting unit 166 may predict the gas generation amount of the battery by using the gas generation amount prediction model, based on the CSR and the ASR. The predicting unit 166 may predict the gas generation amount of the battery by using the gas generation amount prediction model, based on the CSR and the ASR.

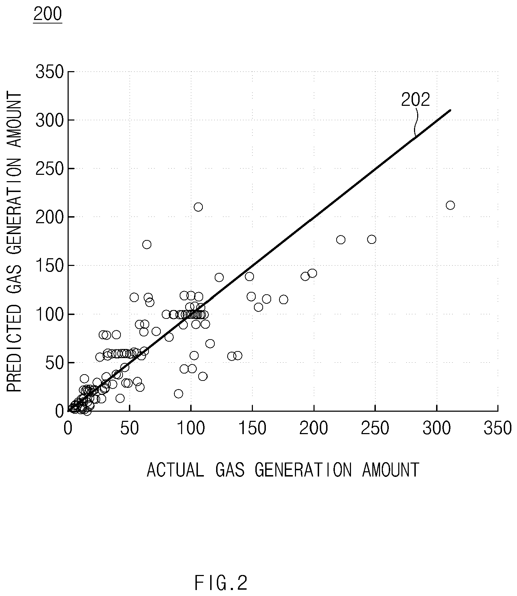

FIG. 2 shows a coordinate system 200 showing a predicted gas generation amount and an actual gas generation amount according to an embodiment of the present disclosure.

Referring to FIG. 2, an x axis of the coordinate system 200 may indicate an actual gas generation amount and a y axis may indicate a predicted gas generation amount.

Coordinates of points of a reference line 202 included in the coordinate system 200 may have the same x and y values.

The comparing unit 170 may compare the predicted gas generation amount with the actual gas generation amount. The comparing unit 170 may compare the predicted gas generation amount with the actual gas generation amount based on the root mean square deviation, the determination coefficient, or a combination thereof for the predicted value and the actual value included in the coordinate system 200.

A root mean square deviation between the predicted gas generation amount and the actual gas generation amount included in the coordinate system 200 may be 26.2567 and determination coefficient may be 0.7264.

The model managing unit 168 may change one or more parameters included in the model governing equation, based on the comparison result. The model managing unit 168 may change one or more parameters included in the model governing equation, based on the root mean square deviation, the determination coefficient, or a combination thereof.

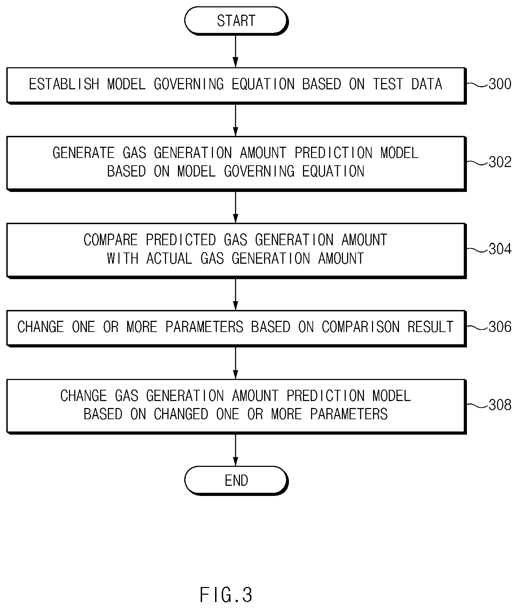

FIG. 3 is a flowchart showing a method of generating and changing a gas generation amount prediction model according to an embodiment of the present disclosure.

Referring to FIG. 3, in operation 300, the model managing unit 168 may establish a model governing equation. The model managing unit 168 may establish the model governing equation based on test data.

In operation 302, the model managing unit 168 may generate a gas generation amount prediction model. The model managing unit 168 may generate a gas generation amount prediction model based on the model governing equation.

In operation 304, the comparing unit 170 may compare the predicted gas generation amount with the actual gas generation amount. The comparing unit 170 may derive the root mean square deviation and the determination coefficient as the comparison result of comparing the predicted gas generation amount with the actual gas generation amount.

In operation 306, the model managing unit 168 may change one or more parameters included in the model governing equation. The model managing unit 168 may change one or more parameters included in the model governing equation, based on the comparison result. The model managing unit 168 may change the one or more parameters to reduce a difference between the predicted gas generation amount and the actual gas generation amount based on the comparison result. The model managing unit 168 may change the one or more parameters included in the model governing equation, based on the root mean square deviation as the comparison result of comparing the predicted gas generation amount with the actual gas generation amount, and the determination coefficient. The model managing unit 168 may change the one or more parameters included in the model governing equation, based on the root mean square deviation as the comparison result of comparing the predicted gas generation amount with the actual gas generation amount, and the determination coefficient, to reduce the difference between the predicted gas generation amount and the actual gas generation amount.

In operation 308, the model managing unit 168 may change the gas generation amount prediction model. The model managing unit 168 may change the gas generation amount prediction model, based on the model governing equation having the changed one or more parameters applied thereto.

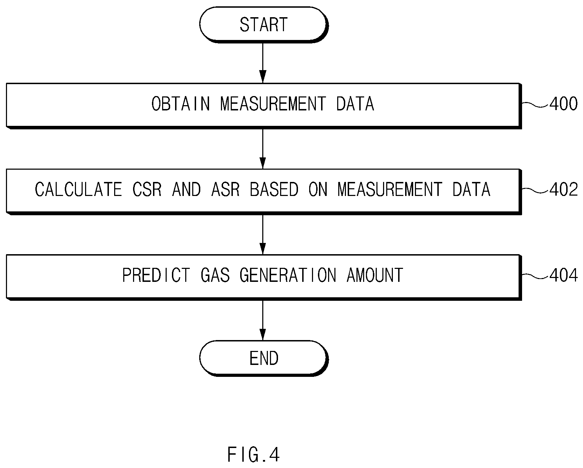

FIG. 4 is a flowchart showing an operating method of the battery gas generation amount prediction apparatus 12 according to an embodiment of the present disclosure.

Referring to FIG. 4, in operation 400, the obtaining unit 162 may obtain data regarding the battery. The obtaining unit 162 may obtain measurement data regarding a voltage, a current, and a temperature of the battery.

In operation 402, the calculating unit 164 may calculate a CSR and an ASR. The calculating unit 164 may calculate the CSR and the ASR based on the measurement data.

In operation 404, the predicting unit 166 may predict the gas generation amount of the battery. The predicting unit 166 may predict the gas generation amount of the battery, based on the CSR and the ASR. Herein, the gas generation amount may be an integral of the gas generation speed.

In operation 406, the predicting unit 166 may predict the gas generation amount of the battery. The predicting unit 166 may predict the gas generation amount based on a gas generation speed. The predicting unit 166 may predict the gas generation amount of the battery by integrating the gas generation speed.

The predicting unit 166 may identify the gas generation speed of the battery to predict the gas generation amount of the battery. The predicting unit 166 may identify the gas generation speed of the battery based on the density of the oxidation reactant and the change rate of the CSR.

The predicting unit 166 may identify a density change rate of the oxidation reactant. The predicting unit 166 may identify the density change rate of the oxidation reactant based on the density of the reduction by-product and the change rate of the ASR. Herein, the density change rate of the oxidation reactant may be reduced as much as the gas generation amount generated by the reduction by-product.

The predicting unit 166 may identify the density of the reduction by-product. The predicting unit 166 may identify the density of the reduction by-product, based on the temperature.

The predicting unit 166 may predict the gas generation amount of the battery by using the gas generation amount prediction model. The predicting unit 166 may predict the gas generation amount of the battery by using the gas generation amount prediction model, based on the CSR and the ASR. The predicting unit 166 may predict the gas generation amount of the battery by using the gas generation amount prediction model, based on the CSR and the ASR.

The predicting unit 166 may predict the gas generation amount of the battery by using the gas generation amount prediction model. The predicting unit 166 may predict the gas generation amount of the battery by using the gas generation amount prediction model, based on the CSR and the ASR. The predicting unit 166 may predict the gas generation amount of the battery by using the gas generation amount prediction model based on the model governing equation, on the basis of the CSR and the ASR.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

**Claims**

1. A gas generation amount prediction apparatus comprising:

   an obtaining unit configured to obtain measurement data regarding a voltage, a current, and a temperature of a battery;
   a calculating unit configured to calculate a cathode side reaction (CSR) and an anode side reaction (ASR), based on the measurement data; and
   a predicting unit configured to predict a gas generation amount of the battery, based on the CSR and the ASR.

2. The gas generation amount prediction apparatus of claim 1, wherein the predicting unit is further configured to:

   identify a gas generation speed of the battery based on a density of an oxidation reactant and a change rate of the CSR; and
   predict the gas generation amount based on the gas generation speed.

3. The gas generation amount prediction apparatus of claim 2, wherein the predicting unit is further configured to identify a change rate of the density of the oxidation reactant based on a density of a reduction by-product and a change rate of the ASR.

4. The gas generation amount prediction apparatus of claim 3, wherein the predicting unit is further configured to identify the density of the reduction by-product based on the temperature.

5. The gas generation amount prediction apparatus of claim 1, further comprising a model managing unit configured to generate a gas generation amount prediction model based on a model governing equation and change one or more parameters included in the model governing equation,
   wherein the predicting unit is further configured to predict the gas generation amount of the battery by using the gas generation amount prediction model.

6. The gas generation amount prediction apparatus of claim 5, further comprising a comparing unit configured to compare a gas generation amount predicted by the gas generation amount prediction model with an actual gas generation amount,
   wherein the model managing unit is further configured to change the one or more parameters included in the model governing equation based on the comparison result.

7. The gas generation amount prediction apparatus of claim 5, wherein the model governing equation comprises an equation based on the gas generation amount and an interactive relationship for CSR-ASR.

8. An operating method of a gas generation amount prediction apparatus, the operating method comprising:

obtaining measurement data regarding a voltage, a current, and a temperature of a battery;

calculating a cathode side reaction (CSR) and an anode side reaction (ASR), based on the measurement data; and

predicting a gas generation amount of the battery, based on the CSR and the ASR.

9. The operating method of claim 8, wherein the predicting comprises identifying a gas generation speed of the battery based on a density of an oxidation reactant and a change rate of the CSR, and

the gas generation amount is predicted based on the gas generation speed.

10. The operating method of claim 9, wherein the predicting further comprises identifying a change rate of the density of the oxidation reactant based on a density of a reduction by-product and a change rate of the ASR.

11. The operating method of claim 10, wherein the predicting further comprises identifying the density of the reduction by-product based on the temperature.

12. The operating method of claim 8, further comprising generating a gas generation amount prediction model based on a model governing equation,

wherein the predicting comprises predicting the gas generation amount of the battery by using the gas generation amount prediction model.

13. The operating method of claim 12, further comprising:

comparing a gas generation amount predicted by the gas generation amount prediction model with an actual gas generation amount; and

changing one or more parameters included in the gas generation amount prediction model, based on the comparison result.

14. The operating method of claim 12, wherein the model governing equation comprises an equation based on the gas generation amount and an interactive relationship for CSR-ASR.

| ELECTRONIC DEVICE 10 | GAS GENERATION AMOUNT PREDICTION APPARATUS 12 | OBTAINING UNIT 162 |
|---|---|---|

BATTERY UNIT 101

BATTERY UNIT 103

BATTERY UNIT 105

COMMUNICATION CIRCUIT 120

SENSOR 140

MEMORY 160

PROCESSOR 180

11

13

USER TERMINAL 14

OBTAINING UNIT 162

CALCULATING UNIT 164

PREDICTING UNIT 166

MODEL MANAGING UNIT 168

COMPARING UNIT 170

FIG.1

FIG.2

```
                    ┌─────────────┐
                    │    START    │
                    └──────┬──────┘
                           │
                           ▼
    ┌───────────────────────────────────────────────────────┐
    │ ESTABLISH MODEL GOVERNING EQUATION BASED ON TEST DATA  │─────300
    └───────────────────────────┬───────────────────────────┘
                                │
                                ▼
    ┌───────────────────────────────────────────────────────┐
    │    GENERATE GAS GENERATION AMOUNT PREDICTION MODEL     │─────302
    │          BASED ON MODEL GOVERNING EQUATION            │
    └───────────────────────────┬───────────────────────────┘
                                │
                                ▼
    ┌───────────────────────────────────────────────────────┐
    │      COMPARE PREDICTED GAS GENERATION AMOUNT          │─────304
    │         WITH ACTUAL GAS GENERATION AMOUNT            │
    └───────────────────────────┬───────────────────────────┘
                                │
                                ▼
    ┌───────────────────────────────────────────────────────┐
    │ CHANGE ONE OR MORE PARAMETERS BASED ON COMPARISON RESULT │───306
    └───────────────────────────┬───────────────────────────┘
                                │
                                ▼
    ┌───────────────────────────────────────────────────────┐
    │     CHANGE GAS GENERATION AMOUNT PREDICTION MODEL     │─────308
    │        BASED ON CHANGED ONE OR MORE PARAMETERS       │
    └───────────────────────────┬───────────────────────────┘
                                │
                                ▼
                    ┌─────────────┐
                    │     END     │
                    └─────────────┘
```

FIG.3

FIG.4

## INTERNATIONAL SEARCH REPORT

| International application No. |
| --- |
| **PCT/KR2023/020680** |

**A. CLASSIFICATION OF SUBJECT MATTER**

**G01R 31/367**(2019.01)i; **G01R 31/385**(2019.01)i; **G01R 31/392**(2019.01)i; **H01M 10/42**(2006.01)i; **H01M 10/48**(2006.01)i; **G01N 33/00**(2006.01)i

According to International Patent Classification (IPC) or to both national classification and IPC

**B. FIELDS SEARCHED**

Minimum documentation searched (classification system followed by classification symbols)

G01R 31/367(2019.01); G01R 31/36(2006.01); H01M 10/42(2006.01); H01M 10/48(2006.01); H02J 7/00(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 가스(gas), 캐소드 부반응(cathode side reaction), 애노드 부반응 (anode side reaction)

**C. DOCUMENTS CONSIDERED TO BE RELEVANT**

| Category* | Citation of document, with indication, where appropriate, of the relevant passages | Relevant to claim No. |
| --- | --- | --- |
| A | KR 10-2020-0046786 A (LG CHEM, LTD.) 07 May 2020 (2020-05-07)<br>See claim 1 and figure 1. | 1-14 |
| A | JP 2018-147742 A (TOYOTA MOTOR CORP.) 20 September 2018 (2018-09-20)<br>See claim 1 and figure 1. | 1-14 |
| A | KR 10-2022-0056150 A (LG ENERGY SOLUTION, LTD.) 04 May 2022 (2022-05-04)<br>See claims 1-3 and figures 1-4. | 1-14 |
| A | KR 10-2018-0100748 A (LG CHEM, LTD.) 12 September 2018 (2018-09-12)<br>See claims 1 and 3. | 1-14 |
| A | JP 2016-093066 A (MITSUBISHI MOTORS CORP.) 23 May 2016 (2016-05-23)<br>See claim 1 and figures 1-2. | 1-14 |

| ☐ Further documents are listed in the continuation of Box C. | ☑ See patent family annex. |
| --- | --- |

\* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **19 March 2024** | **19 March 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/020680**

| Patent document cited in search report | | | Publication date (day/month/year) | Patent family member(s) | | | Publication date (day/month/year) |
|---|---|---|---|---|---|---|---|
| KR | 10-2020-0046786 | A | 07 May 2020 | CN | 111656207 | A | 11 September 2020 |
| | | | | CN | 111656207 | B | 12 July 2022 |
| | | | | EP | 3722822 | A1 | 14 October 2020 |
| | | | | EP | 3722822 | B1 | 17 August 2022 |
| | | | | US | 11506721 | B2 | 22 November 2022 |
| | | | | US | 2021-0048481 | A1 | 18 February 2021 |
| | | | | WO | 2020-085667 | A1 | 30 April 2020 |
| JP | 2018-147742 | A | 20 September 2018 | JP | 6731159 | B2 | 29 July 2020 |
| KR | 10-2022-0056150 | A | 04 May 2022 | CN | 115443416 | A | 06 December 2022 |
| | | | | EP | 4148444 | A1 | 15 March 2023 |
| | | | | JP | 2023-519692 | A | 12 May 2023 |
| | | | | JP | 7400172 | B2 | 19 December 2023 |
| | | | | US | 2023-0140094 | A1 | 04 May 2023 |
| | | | | WO | 2022-092827 | A1 | 05 May 2022 |
| KR | 10-2018-0100748 | A | 12 September 2018 | | None | | |
| JP | 2016-093066 | A | 23 May 2016 | JP | 6447029 | B2 | 09 January 2019 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220182369

- KR 1020230153022